# EUROPEAN PATENT SPECIFICATION

(11) **EP 1 494 324 B1**
(45) Date of publication and mention of the grant of the patent: **06.02.2008**
(21) Application number: 03024908.0
(22) Date of filing: 28.10.2003
(51) Int. Cl.: H01S 5/0683, G01V 8/12

(54) **Semiconductor laser drive circuit and photoelectric sensor**
Halbleiterlaseransteuerschaltung und photoelektrischer Sensor.
Circuit de commande du laser à semiconducteur et un capteur photo-électrique

(30) Priority: 30.06.2003 JP 2003188616
(43) Date of publication of application: 05.01.2005
(73) Proprietor: Sunx Limited, Kasugai-shi, Aichi (JP)
(72) Inventor: Ochiai, Takayuki, Kasugai-shi Aichi (JP); Takeda, Takayuki, Kasugai-shi Aichi (JP)
(74) Representative: Müller-Boré & Partner Patentanwälte

(56) References cited:
- PATENT ABSTRACTS OF JAPAN vol. 013, no. 459 (E-832), 17 October 1989 (1989-10-17) -& JP 01 179382 A (RICOH CO LTD), 17 July 1989 (1989-07-17)
- PATENT ABSTRACTS OF JAPAN vol. 2002, no. 04, 4 August 2002 (2002-08-04) & JP 2001 336929 A (SUNX LTD), 7 December 2001 (2001-12-07)

## Description

The present invention relates to a semiconductor laser drive circuit and a photoelectric sensor provided with the circuit.

Photoelectric sensors of the light transmission type generally comprise a light emitting element and a light receiving or detecting element both opposed to each other. Laser beams emitted by the light emitting element are blocked by an object when the object is placed in the middle of a light path from the light emitting element to the light receiving element. An amount of light received by the light receiving element varies depending upon the presence or absence of an object in the middle of the light path. Thus, the presence or absence of the object is detected, or the position or dimensions of the object are measured on the basis of variations in the amount of light received by the light receiving element of the photoelectric sensor. In order that the photoelectric sensor may perform a stable detection or measurement, output of the light emitting element is required to be constant.

For the purpose of obtaining a constant output, a semiconductor laser drive circuit has conventionally been provided in the photoelectric sensor. The semiconductor laser drive circuit carries out an automatic power control (APC) to control the light emitting element so that output of the element is rendered constant. The semiconductor laser drive circuit includes a laser diode serving as the foregoing light emitting element and a monitor photodiode mounted in the same chip along with the mounted laser diode. An amount of electric current flowing into the monitor photodiode changes in response to an amount of light emitted by the laser diode. A feedback control loop is carried out on the basis of an amount of current flowing into the monitor photodiode so that the output level of the laser diode maintains a predetermined intensity.

In one type of the laser diode having a built-in monitor photodiode, a cathode of the laser diode and an anode of the monitor photodiode are connected in common. Recently, however, another type of laser diode has appeared in which cathodes of both diodes are connected in common has mainly been used. This type is often referred to as a "cathode common connection type." The laser diode of the cathode common connection type commonly available at low costs due to the benefits of mass production.

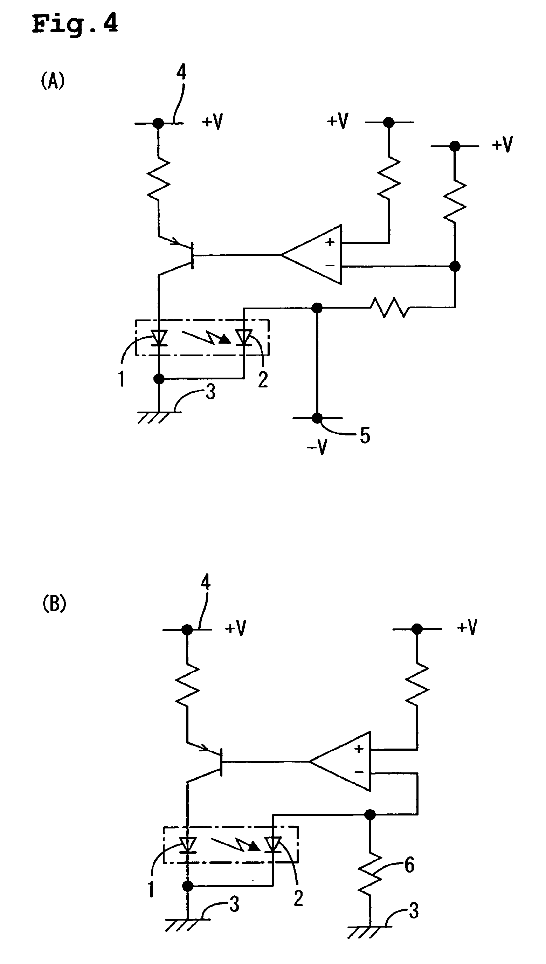

FIGS. 4A and 4B illustrate arrangements of conventional semiconductor laser drive circuits employing laser diodes of the cathode common type respectively. JP-A-61-202345 and Japanese Patent No. 2540850 disclose semiconductor laser drive circuits of the cathode common connection type.

In the laser diode of the cathode common connection type, the cathodes of the laser diode 1 and monitor photodiode 2 are connected in common as described above. Accordingly, the cathodes are connected in common to a ground line 3 in the circuit as shown in FIG. 4A. Furthermore, the laser diode 1 is connected between the ground line 3 and a positive power supply 4, whereas the monitor photodiode 2 is connected between the ground line 3 and a negative power supply 5. Thus, the circuit shown in FIG. 4A requires two power supplies 4 and 5, which complicates a power supply circuit and increases a mounting or packaging area. The requirement of the two power supplies limits potential reduction in the size of the overall device and results in a cost increase.

On the other hand, in the circuit shown in FIG. 4B, only the positive power supply 4 is used without the negative power supply. However, no reverse voltage is applied to the monitor photodiode 2 and accordingly, the photodiode is unbiased. Consequently, even when the monitor photodiode 2 receives or detects light, a linear current flow does not respond quickly to the detection. This results in a delay in the build-up of load voltage of a resistor 6 connected in parallel to the monitor photodiode 2. Accordingly, a high-speed APC cannot be realized in the circuit shown in FIG. 4B.

Patent Abstracts of Japan, vol. 0134, Nr. 59, E-832 (JP 01 179 382-A) discloses a system for controlling the quantity of light outputted by a laser diode. The laser diode is driven by a current controlled through a current control transistor. The anode of a biasing diode is connected to a common terminal of cathodes of the laser diode as well as a photo diode. The cathode of said biasing diode is connected to a ground. A load resistor connects the anode of the photo diode to ground as well. Thus a monitor current flowing through the photo diode is detected as a voltage drop over the load resister by a differential amplifier. In a feedback manner the differential amplifier controls the current control transistor depending on the detected voltage drop, which is measure of the outputted laser light detected by the photo diode.

Therefore, an object of the present invention is to provide a semiconductor laser drive circuit that is a drive circuit for a semiconductor laser element. Components of the semiconductor laser element could include a semiconductor laser drive diode and a monitor photodiode both having their respective cathodes connected in common. In addition, an object of the present invention is to provide a semiconductor laser drive circuit that can realize a high-speed control with use of a single power supply. A further object includes, but is not limited to, a photoelectric sensor provided along with the semiconductor laser drive circuit.

To achieve the various objects identified and others not identified, the present invention provides a semiconductor laser drive circuit for a semiconductor laser element including a semiconductor laser drive diode and a monitor photodiode both having respective cathodes connected in common, wherein the semiconductor laser diode has an anode connected to a power supply line side and the monitor photodiode has an anode connected to a ground line side via a voltage generating unit generating voltage according to an amount of current flowing into the monitor photodiode. The semiconductor laser drive circuit comprises a current control element adjusting an amount of current supplied to the semiconductor laser diode, a feedback control unit receiving a voltage generated by the voltage generating element to supply a control signal to a control terminal of the current control element based upon the relationship of a reference voltage level to the voltage generated, thereby controlling in a feedback manner the output laser beam of the semiconductor laser diode so as to maintain the output laser beam at a predetermined level, and a biasing element provided between the common cathode connections of the semiconductor laser diode and the monitor photodiode, and the ground line, the biasing element applying a reverse bias voltage to the monitor photodiode.

When the light receiving unit receives light emitted by the light emitting unit, a current relating to an amount of received light flows into the monitor photodiode. The voltage generating element may then generate a voltage with a level corresponding to the amount of current. The feedback control unit may deliver a control signal to the current control element proportionate to to the generated voltage level. The delivered control signal may be one corresponding to a difference between the level of voltage generated by the voltage generating element and a reference voltage level corresponding to a known laser output level of the semiconductor laser diode, for example. Consequently, the laser light output of the semiconductor laser diode may be controlled to correspond to a predetermined level (the aforesaid known laser output level).

In the above-described semiconductor laser drive circuit, the laser light output of the semiconductor laser diode can be controlled in the feedback manner with the use of a single power supply. Furthermore, since the biasing element applies the reverse bias voltage (reverse voltage) to the monitor photodiode, current flowing into the monitor photodiode can be rendered linear relative to variations in an amount of light received by the monitor light receiving element. Consequently, a high-speed feedback control loop can be realized.

In a preferred form, the current control element is connected in series between the cathode connection of the semiconductor laser diode and the monitor photodiode, and the biasing element. In this arrangement, only the current control element and semiconductor laser diode can be connected between the biasing element (examples include but are not limited to a resistor or Zener diode) and the power supply line. Consequently, since a high level voltage corresponding to a load voltage of the aforesaid resistor is applied as the reverse bias voltage to the monitor photodiode, current levels flowing into the monitor photodiode can respond quickly to variations in light detected or received by the photodiode.

The present invention also provides a photoelectric sensor comprising a light emitting unit emitting light directed to a predetermined detection region and a light receiving unit receiving light from the detection region, thereby performing a detecting operation according to a level of the light received by the receiving unit, the light emitting unit including a semiconductor laser drive circuit for a semiconductor laser element including a semiconductor laser drive diode and a monitor photodiode both having respective cathodes connected in common, wherein the semiconductor laser diode has an anode connected to a power supply line side and the monitor photodiode has an anode connected to a ground line side via a voltage generating unit generating voltage according to an amount of current flowing into the monitor photodiode. The semiconductor laser drive circuit comprises a current control element adjusting an amount of current supplied to the semiconductor laser diode, a feedback control unit receiving a voltage generated by the voltage generating element to supply a control signal to a control terminal of the current control element based upon the relationship of a reference voltage level to the voltage generated, thereby controlling in a feedback manner the output laser beam of the semiconductor laser diode so as to maintain the output laser beam at a predetermined level, and a biasing element provided between the common cathode connection of the semiconductor laser diode and the monitor photodiode, and the ground line, the biasing element applying a reverse bias voltage to the monitor photodiode.

The foregoing semiconductor laser drive circuit can be employed in the photoelectric sensor. Consequently, the semiconductor laser diode can be controlled at a higher speed, and with a lower response time in the detection or measurement of an object. Furthermore, the size of the photoelectric sensor can be reduced beyond that of a photoelectric sensor in which two power supplies have been used.

Other objects, advantages and features of the present invention will become clear upon reviewing the following description of embodiment, made with reference to the accompanying drawings, in which:
FIG. 1 illustrates an overall construction of a photoelectric sensor in accordance with an embodiment of the present invention;
FIG. 2 is a schematic circuit diagram of the semiconductor laser drive circuit in accordance with the present invention;
FIG. 3 is a circuit diagram of the semiconductor laser drive circuit representing technical background ; and
FIGS. 4A and 4B are circuit diagrams of conventional two power source and one power source common cathode connection type semiconductor laser drive circuits respectively.

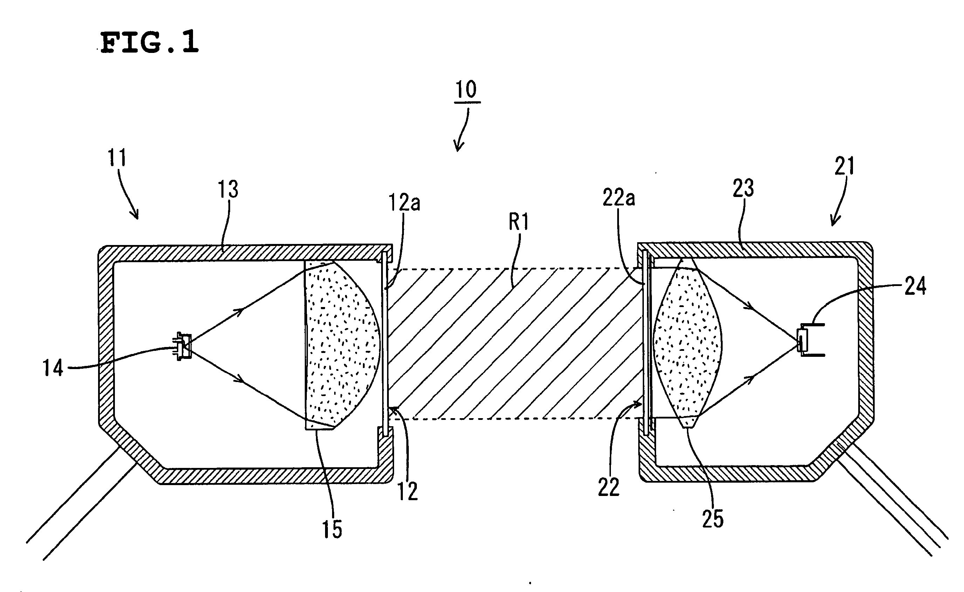

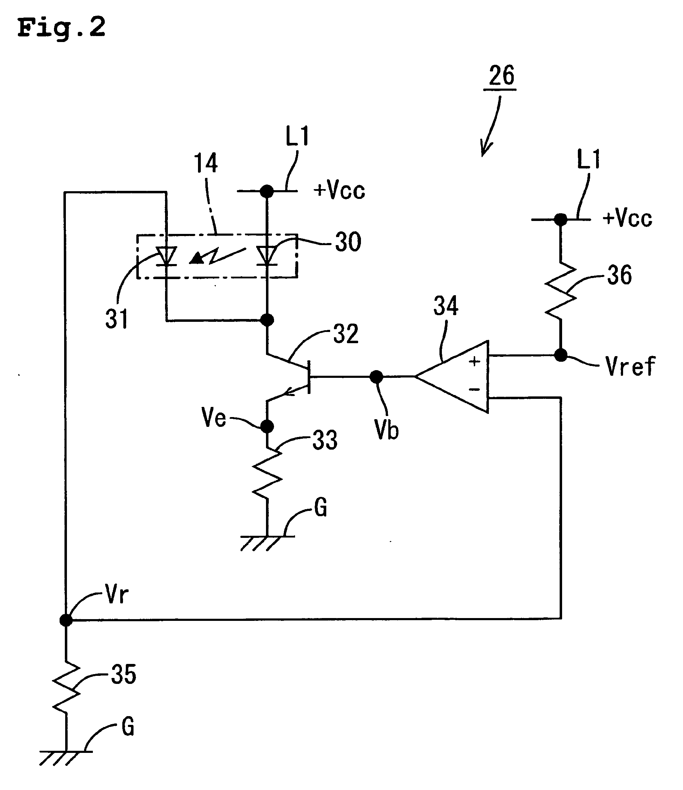

An embodiment of the present invention will be described with reference to FIGS. 1 and 2. A transmittance photoelectric sensor 10 of the embodiment includes a light emitting section 11 having a rectangular slit-like emitting window 12 from which parallel rays of light are emitted and a light receiving section 21 also having a rectangular slit-like light receiving window 22. The light emitting section 11 and the light receiving section 21 are disposed to be opposed to each other. Light emitted from the light emitting window 12 of the light emitting section 11 impinges into the light receiving window 22 of the light receiving section 21. A light path between the windows 12 and 22 is set as a detectable region R1 for the photoelectric sensor 10. The region R1 is defined by broken lines in FIG. 1. When an object is present in the region R1, light emitted from the light emitting window 12 is blocked by the object. An amount of light received by the light receiving section 21 varies depending upon a degree of blocking. For example, dimensions of the object are measured on the basis of an amount of light received by the light receiving section 21.

The light emitting section 11 comprises a light emitting case 13, a semiconductor chip 14 serving as a semiconductor laser element in the invention and a light emitting lens 15 disposed in front of the semiconductor chip. The semiconductor chip 14 includes a laser diode 30 and a monitor photodiode 31 both enclosed in the same package. The laser diode 30 and the monitor photodiode 31 have respective cathodes connected in common. The lens 15 is, for example, a thick semicircular plate-shaped concavoconvex lens. The lens 15 is disposed so that a convex portion thereof is located at the light emitting window 12 side. The lens 15 converts radially spread light emitted by the laser diode 30 to the parallel rays traveling to the opposed light receiving section 21 side. The light emitting case 13 includes a wall located in front of the lens 15 and formed with a slit-like opening which is closed by a light transmitting member 12a such as glass, whereby the light emitting window 12 is formed.

The light receiving section 21 comprises a light receiving case 23, a light receiving or detecting element 24 and a light receiving lens 25 converging the parallel rays from the light emitting section 11. The light receiving case 23 also includes a wall located in front of the lens 25 and formed with a slit-like opening which is closed by a light transmitting member 22a such as glass, whereby the light emitting window 22 is formed. The light emitting and receiving sections 11 and 21 are disposed to be opposed to each other while long axes correspond with each other.

The semiconductor laser drive circuit will now be described. The laser light output of the laser diode 30 needs to be maintained at a constant value in order that the transmittance photoelectric sensor 10 may perform a stable detection or measurement. For this purpose, a semiconductor laser drive circuit 26 is provided. Referring to FIG. 2, reference numeral 14 designates the aforesaid semiconductor chip. The laser diode 30 has an anode connected to a power supply line L1 and a cathode to which a collector of an NPN transistor 32 is connected. The cathodes of the monitor photodiode 31 and the laser diode 30 are connected to a common node. The NPN transistor 32 serves as a current control element in the invention. The NPN transistor 32 has an emitter connected via an emitter resistor 33 to a ground line G. The emitter resistor 33 is a variable resistor so that the speed of the APC can be adjusted and/or optimized. The emitter resistor 33 serves as a biasing element in the invention. The NPN transistor 32 further has a base connected to an output terminal of a differential amplifier 34. The NPN transistor 32 controls an amount of current flowing into the laser diode 30 according to a level of control signal delivered from the differential amplifier 34.

The monitor photodiode 31 has an anode connected via a resistor 35 to the ground line G. Load voltage of the resistor 35 takes a value according to an amount of current flowing into the monitor photodiode 31. Accordingly, the resistor 35 serves as a voltage generating unit in the invention. The resistor 35 will hereinafter be referred to as "current detecting resistor." A voltage level Vᵣ at a node of the resistor 35 and the monitor photodiode 31 is supplied to one input of the differential amplifier 34. The other input of the differential amplifier 34 is connected via a resistor 36 to the power supply line L1, whereby a predetermined reference voltage level V_{ref} is supplied to said other input of the differential amplifier. Thus, the differential amplifier 34 supplies, to the base of NPN transistor 32, a control signal with a level according to the difference between the aforesaid reference voltage level V_{ref} and the voltage level Vᵣ varying according to the current flowing into the monitor photodiode 31.

The above-described semiconductor laser drive circuit 26 operates as follows. When a positive power supply voltage level V_{cc} is applied to the power supply line L1, the voltage level Vᵣ applied to the input of the differential amplifier 34 is lower than the reference level V_{ref} since the monitor photodiode 31 receives no light from the laser diode 30 at an initial stage. Accordingly, the voltage level at the base of the NPN transistor 32 (hereinafter, "base voltage level V_{b}") is high so that the NPN transistor is turned on. A corresponding amount of current flows into the laser diode 30, so that the laser diode emits light. Since current also flows into the emitter resistor 33 in this case, the emitter voltage level Vₑ of the NPN transistor 32 becomes substantially equal to a voltage level obtained by subtracting a voltage drop V_{d} across the laser diode 30 from the power supply voltage level (V_{cc} - V_{d}). The emitter voltage level Vₑ is supplied to the monitor photodiode 31 and current detecting resistor 35. In other words, a reverse bias voltage (reverse voltage) is applied to the monitor photodiode 31. The level of this reverse bias voltage varies during the APC. However, an amount of current flowing from the diode 30 to the photodiode 31 is smaller than an amount of current flowing into the NPN transistor 32. Consequently, an amount of current according to an amount of light received by the photodiode 31 can be supplied to the current detecting resistor 35 serving as the voltage generating element without adverse effect of variations in the aforesaid reverse bias voltage. In short, the voltage level Vᵣ is barely adversely affected by the variations in the reverse bias voltage level.

On the other hand, the monitor photodiode 31 receives light emitted by the laser diode 30. An amount of current according to an amount of received light flows into the photodiode 31. Since the reverse bias voltage is applied to the photodiode 31, the amount level of current flowing into the photodiode 31 quickly rises upon receipt of light. The current amount level thereafter varies in a linear mode relative to the variations in the amount of received light. This voltage level Vᵣ varying in the linear mode relative to the variations in the amount of received light is supplied to the input of the differential amplifier 34.

An amount of light received by the photodiode 31 is increased as the laser light output of the laser diode 30 becomes higher. When the difference between the voltage level Vᵣ and the reference voltage level V_{ref} becomes smaller, the level of the control signal delivered from the differential amplifier 34 drops and accordingly, the base voltage level V_{b} of the NPN transistor 32 drops. As a result, an amount of current flowing into the laser diode 30 is decreased. Conversely, when an amount of light emitted by the laser diode 30 is reduced, the difference between the voltage level Vᵣ and the reference voltage level V_{ref} becomes larger, so that the base voltage level V_{b} of the NPN transistor 32 is increased. As a result, an amount of current flowing into the laser diode 30 is also increased. Consequently, the output of the laser diode 30 can be maintained at the set level corresponding to V_{ref}.

In the above-described embodiment, the APC can be carried out with use of a single power supply even when the semiconductor ship 14 of the cathode common type includes the laser diode 30 and the monitor photodiode 31 with their respective cathodes connected in common. Moreover, since the reverse bias voltage is applied to the monitor photodiode 31, linear current can quickly be supplied to the photodiode 31 corresponding to the variations in the amount of light emitted by the laser diode 30 and the variations in the mount of light received by the monitor photodiode 31, as compared with the a circuit arrangement in the aforesaid unbiased state. Consequently, a higher-speed feedback control can be realized with the biasing element.

In the above-described embodiment, only the NPN transistor 32 and laser diode 30 are connected between the emitter resistor 33 (as the biasing element) and the power supply line L1. Accordingly, a high voltage level corresponding to the load voltage of the emitter resistor 33 is applied as the reverse bias voltage to the monitor photodiode 31. Consequently, allowing the current flowing into the photodiode 31 to respond more quickly than without the reverse bias voltage.

Furthermore, when the above-described semiconductor laser drive circuit is employed in the transmittance photoelectric sensor 10, a high-speed control of the laser diode 30 can be realized and accordingly, a response time in the detection or measurement of the object can be reduced. Furthermore, the size of the light emitting section 11 and the size of the overall photoelectric sensor 10 can be smaller than in comparison to an arrangement in which two power supplies have been used.

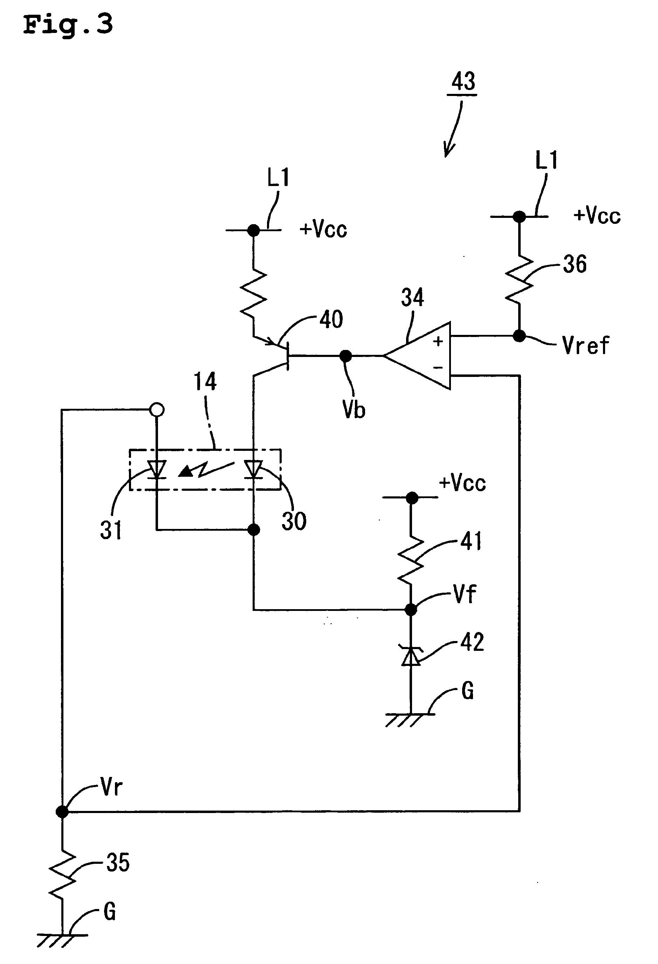

FIG. 3 illustrates another embodiment representing technical background. One difference between the second embodiment and the previous one is that a PNP transistor 40 is employed as the current control element, instead of the NPN transistor 32, respectively. Furthermore, the configuration of the biasing element is different than the configuration of biasing element presented in the first embodiment.

Referring to FIG. 3, the PNP transistor 40 (serving as a current control element) is connected between the power supply line L1 and the anode of the laser diode 30. A resistor 41 is connected in series to a Zener diode 42 between the power supply line L1 and the ground line G. The cathodes of the laser diode 30 and the monitor photodiode 31 are connected to the node between the resistor 41 and the Zener diode 42. As the result of this arrangement, voltage applied to the Zener diode 42 is applied as the reverse bias voltage to the monitor photodiode 31 to which the Zener diode is connected in parallel.

In the second embodiment, the APC control can also be carried out with use of a single power supply even when the semiconductor chip 14 of the cathode common type is employed. Moreover, since the reverse bias voltage is applied to the monitor photodiode 31, a high-speed feedback control, as compared to non-biased configurations, can be realized.

Furthermore, when the above-described semiconductor laser drive circuit 26 is provided in the transmittance type photoelectric sensor 10, a high-speed control of the laser diode 30 can be realized and accordingly, a response time in the detection or measurement of the object can be reduced. Furthermore, the size of the light emitting section 11 and the size of the overall photoelectric sensor 10 can be rendered smaller than in an arrangement in which two power supplies have been used.

Several modified forms will be described, but not limited to the following. The semiconductor laser drive circuit 26 is described as applied to the transmittance type photoelectric sensor 10 in the foregoing embodiments. However, the semiconductor laser drive circuit 26may also be applied to reflection type photoelectric sensors as well. Additionally, the semiconductor laser drive circuit 26 may be applied to optical pickup devices such as those currently provided in compact disc (CD) players and digital versatile disc (DVD) players as well as bar code readers/scanners.

The resistor 36 may be replaced with a variable resistor in each of the foregoing embodiments. In such a situation, the reference voltage level V_{ref} can be varied so that the resulting level of output of the laser diode 30 is modified. Additionally, the bipolar transistor is used as the current control element in each embodiment. However, a field-effect transistor (FET) may be used in place of the bipolar transistor as the current control element.

The foregoing description and drawings are merely illustrative of the principles of the present invention and are not to be construed in a limiting sense. Various changes and modifications will become apparent to those of ordinary skill in the art. All such changes and modifications are seen to fall within the scope of the invention as defined by the appended claims.

## Claims

1. A semiconductor laser drive circuit (26) for a semiconductor laser element including a semiconductor laser diode (30) and a monitor photodiode (31) both having respective cathodes connected in common, wherein the semiconductor laser diode (30) has an anode connected to a power supply line (L1) side and the monitor photodiode has an anode connected to a ground line (G) side via a resistor (35) generating voltage according to an amount of current flowing into the monitor photodiode (31), the semiconductor laser drive circuit (26, 43) comprising:
a current control element(32) adjusting an amount of current supplied to the semiconductor laser diode (30);
a feedback control unit (34) receiving a voltage (Vr) generated by the resistor (35) to supply a control signal (Vb) to a control terminal of the current control element (32) based upon the relationship of a reference voltage level (Vref) to the voltage (Vr) generated, thereby controlling in a feedback manner the output laser beam of the semiconductor laser diode (30) so as to maintain the output laser beam at a predetermined level; and
a biasing element (33) provided between the common cathode connection of the semiconductor laser diode (30) and the monitor photodiode (31), and the ground line(G), the biasing element (33) applying a reverse bias voltage to the monitor photodiode (31),
**characterized in that** the biasing element is a variable resistor allowing for variable adjustment of the speed of the feedback control loop.

2. A semiconductor laser drive circuit (26) according to claim 1, wherein the current control element (32) is provided between the cathode connection of the semiconductor laser diode (30) and the monitor photodiode (31), and the ground line(G).

3. A semiconductor laser drive circuit (26) according to claim 2, wherein the current control element (32) is connected in series to the biasing element (33) between the cathode connection of the semiconductor laser diode (30) and the monitor photodiode (31), and the biasing element(33).

4. A semiconductor laser drive circuit (26) according to one of the preceding claims, wherein the reference voltage (Vref) is provided through a variable resistor such that the reference voltage level (Vref) is variable so that the resulting level of output of the laser diode (30) is modifiable.

5. A semiconductor laser drive circuit (26) according to one of the preceding claims, wherein the current control element (32) comprises a bi-polar transistor.

6. A semiconductor laser drive circuit (26) according one of the preceding claims, wherein the current control element(32) comprises a field-effect transistor.

7. A photoelectric sensor (10) comprising a light emitting unit (11) emitting light directed to a predetermined detection region (R1) and a light receiving unit (21) receiving light from the detection region (R1), thereby performing a detecting operation according to a level of the light received by the light receiving unit (21), the light emitting unit (11) including a semiconductor laser drive circuit (26) for a semiconductor laser element including a semiconductor laser drive diode (30) and a monitor photodiode (31) both having respective cathodes connected in common, wherein the semiconductor laser diode (30) has an anode connected to a power supply line (L1) side and the monitor photodiode (31) has an anode connected to a ground line (G) side via a resistor (35) generating voltage according to an amount of current flowing into the monitor photodiode (31), the semiconductor laser drive circuit (26) comprising:
a current control element (32) adjusting an amount of current supplied to the semiconductor laser diode (30);
a feedback control unit (34) receiving a voltage (Vr) generated by the resistor (35) to supply a control signal (Vb) to a control terminal of the current control element (32) based upon the relationship of a reference voltage level (Vref) to the voltage (Vr) generated, thereby controlling in a feedback manner the output laser beam of the semiconductor laser diode (30) so as to maintain the output laser beam at a predetermined level; and
a biasing element(33) provided between the common cathode connection of the semiconductor laser diode (30) and the monitor photodiode (31), and the ground line(G), the biasing element(33) applying a reverse bias voltage to the monitor photodiode (31),
**characterized in that** the biasing element is a variable resistor allowing for modification of the speed of the feedback control loop.

8. A photoelectric sensor (10) according to claim 7, wherein the current control element (32) is provided between the cathode connection of the semiconductor laser diode (30) and the monitor photodiode (31), and the ground line.

9. A photoelectric sensor (10) according to claim 7 or 8, wherein the current control element (32) is connected in series to the biasing element (33) between the cathode connection of the semiconductor laser diode (30) and the monitor photodiode (31), and the biasing element(33).

10. A photoelectric sensor (10) according to claim 7, 8, or 9, wherein the reference voltage(Vref) is provided through a variable resistor such that the reference voltage level (V_{ref}) is variable so that the resulting level of output of the laser diode (30) is modifiable.

11. A photoelectric sensor (10) according to one of claims 7 to 10, wherein the current control element (32) comprises a bi-polar transistor.

12. A photoelectric sensor according one of claims 7 to 11, wherein the current control element comprises a field-effect transistor.

## Patentansprüche

1. Halbleiterlasersteuerkreis (26) für ein Halbleiterlaserbauteil, einschließlich einer Halbleiterlaserdiode (30) und einer Monitorphotodiode bzw. Kontrollphotodiode (31), beide mit jeweiligen Kathoden gemeinsam verbunden, wobei die Halbleiterlaserdiode (30) eine Anode aufweist, angeschlossen an eine Leistungsversorgungsleitungs-(L1)-seite und die Monitorphotodiode eine Anode aufweist, angeschlossen an die Erdleitungs-(G)-seite über einen Widerstand (35), der Spannung gemäß einer Menge an Stromfluss zu der Monitorphotodiode (31) erzeugt, wobei der Halbleiterlasersteuerkreis (26, 43) umfasst:
ein Stromsteuerbauteil bzw. Stromregelungsbauteil (32) zum Einstellen einer Strommenge, zugeführt zu der Halbleiterlaserdiode (30);
eine Rückkopplungssteuereinheit bzw. Rückkopplungsregeleinheit (34), die eine Spannung (Vr), erzeugt durch den Widerstand (35), erhält, zur Zufuhr eines Steuersignals bzw. Regelsignals (Vb) zu einem Steueranschluss bzw. Regelanschluss des Stromsteuerbauteils (32), basierend auf dem Verhältnis eines Referenzspannungswerts (Vref) zu der erzeugten Spannung (Vr), wodurch in Rückkopplungsweise der Ausgangslaserstrahl der Halbleiterlaserdiode (30) so gesteuert bzw. geregelt wird, dass der Ausgangslaserstrahl bei einem vorbestimmten Wert beibehalten wird; und
ein Vorspannungsbauteil (33), bereitgestellt zwischen dem gemeinsamen Kathodenanschluss von der Halbleiterlaserdiode (30) und der Monitorphotodiode (31), und der Erdleitung (G), wobei das Vorspannungsbauteil (33) eine umgekehrte Vorspannung an die Monitorphotodiode (31) anlegt,
**dadurch gekennzeichnet, dass** das Vorspannungsbauteil ein variabler Widerstand ist, der variable Einstellung der Geschwindigkeit der Rückkopplungssteuerungsschleife bzw. Rückkopplungsregelungsschleife gestattet.

2. Halbleiterlasersteuerkreis (26) nach Anspruch 1, wobei das Stromsteuerbauteil (32) zwischen dem Kathodenanschluss von der Halbleiterlaserdiode (30) und der Monitorphotodiode (31), und der Erdleitung (G) bereitgestellt ist.

3. Halbleiterlasersteuerungskreis (26) nach Anspruch 2, wobei das Stromsteuerbauteil (32) in Reihe zu dem Vorspannungsbauteil (33) zwischen dem Kathodenanschluss der Halbleiterlaserdiode (30) und der Monitorphotodiode (31) und dem Vorspannungsbauteil (33) angeschlossen wird.

4. Halbleiterlasersteuerkreis (26) nach einem der vorangehenden Ansprüche, wobei die Referenzspannung (Vref) über einen variablen Widerstand bereitgestellt wird, sodass der Referenzspannungswert (Vref) so variabel ist, dass der erhaltene Wert des Ausgangs der Laserdiode (30) modifizierbar ist.

5. Halbleiterlasersteuerkreis (26) nach einem der vorangehenden Ansprüche, wobei das Stromsteuerbauteil (32) einen bipolaren Transistor umfasst.

6. Halbleiterlasersteuerkreis (26) nach einem der vorangehenden Ansprüche, wobei das Stromsteuerbauteil (32) einen Feldeffekttransistor umfasst.

7. Photoelektrischer Sensor (10), umfassend eine Licht emittierende Einheit (11), die Licht zu einem vorbestimmten Detektionsbereich (R1) emittiert, und eine Lichtempfangseinheit (21), die Licht von dem Detektionsbereich (R1) empfängt, wodurch ein Detektionsvorgang gemäß einem Wert des Lichtes, empfangen durch die Licht empfangende Einheit (21), ausgeführt wird, wobei die Licht emittierende Einheit (11) einen Halbleiterlasersteuerkreis (26) für ein Halbleiterlaserbauteil, einschließlich einer Halbleiterlasersteuerdiode (30) und einer Monitorphotodiode (31), beide mit jeweiligen Kathoden gemeinsam verbunden, einschließt, wobei die Halbleiterlaserdiode (30) eine Anode aufweist, die an eine Stromversorgungsleitungs-(L1)-seite angeschlossen ist und die Monitorphotodiode (31) eine Anode aufweist, die an eine Erdleitungs-(G)-seite über einen Widerstand (35) angeschlossen ist, der eine Spannung gemäß einer Menge an Stromfluss zu der Monitorphotodiode (31) erzeugt, wobei der Halbleiterlasersteuerkreis (26) umfasst:
ein Stromsteuerbauteil bzw. Stromregelungsbauteil (32) zum Einstellen einer Strommenge, zugeführt zu der Halbleiterlaserdiode (30);
eine Rückkopplungssteuereinheit bzw. Rückkopplungsregeleinheit (34) zum Empfang einer Spannung (Vr), erzeugt durch den Widerstand (35), zur Zuführung eines Steuer- bzw. Regelsignals (Vb) zu einem Steuerungs- bzw. Regelungsanschluss des Stromsteuerbauteils (32), basierend auf dem Verhältnis eines Referenzspannungswerts (Vref) zu der erzeugten Spannung (Vr), wodurch in Rückkopplungsweise der Ausgangslaserstrahl der Halbleiterlaserdiode (30) so gesteuert wird, dass der Ausgangslaserstrahl bei einem vorbestimmten Wert beibehalten wird; und
ein Vorspannungsbauteil (33), bereitgestellt zwischen dem gemeinsamen Kathodenanschluss von der Halbleiterlaserdiode (30) und der Monitorphotodiode (31), und der Erdleitung (G), wobei das Vorspannungsbauteil (33) eine umgekehrte Vorspannung an die Monitorphotodiode (31) anlegt,
**dadurch gekennzeichnet, dass** das Vorspannungsbauteil ein variabler Widerstand ist, der die Modifizierung der Geschwindigkeit der Rückkopplungssteuerungs- bzw. Regelungsschleife erlaubt.

8. Photoelektrischer Sensor (10) nach Anspruch 7, wobei das Stromsteuerbauteil (32) zwischen dem Kathodenanschluss von der Halbleiterlaserdiode (30) und der Monitorphotodiode (31) und der Erdleitung bereitgestellt ist.

9. Photoelektrischer Sensor (10) nach Anspruch 7 oder 8, wobei das Stromsteuerbauteil (32) in Reihe zu dem Vorspannungsbauteil (33) zwischen dem Kathodenanschluss von der Halbleiterlaserdiode (30) und der Monitorphotodiode (31), und dem Vorspannungsbauteil (33) angeschlossen ist.

10. Photoelektrischer Sensor (10) nach Anspruch 7, 8 oder 9, wobei die Referenzspannung (Vref) über einen variablen Widerstand bereitgestellt wird, sodass der Referenzspannungswert (Vref) so variabel ist, dass der erhaltene Wert des Ausgangs der Laserdiode (30) modifizierbar ist.

11. Photoelektrischer Sensor (10) nach einem der Ansprüche 7 bis 10, wobei das Stromsteuerbauteil (32) einen bipolaren Transistor umfasst.

12. Photoelektrischer Sensor nach einem der Ansprüche 7 bis 11, wobei das Stromsteuerbauteil einen Feldeffekttransistor umfasst.

## Revendications

1. Circuit de commande du laser à semi-conducteur (26) pour un élément de laser à semi-conducteur incluant une diode laser à semi-conducteur (30) et une photodiode de monitor (31), les deux ayant des cathodes respectives connectées en commun, dans lequel la diode laser à semi-conducteur (30) a une anode connectée à un côté de conducteur d'alimentation en courant (L1) et dans lequel la photodiode de monitor a une anode connectée à un côté de conducteur de terre (G) par l'intermédiaire d'une résistance (35) qui génère une tension conformément à une quantité de courant passant jusque dans la photodiode de monitor (31), le circuit de commande du laser à semi-conducteur (26, 43) comprenant :
un élément de contrôle du courant (32) qui ajuste une quantité de courant fournie à la diode laser à semi-conducteur (30) ;
une unité de contrôle de rétroaction (34) qui reçoit une tension (Vr) générée par la résistance (35) afin de fournir un signal de contrôle (Vb) à un terminal de contrôle de l'élément de contrôle du courant (32) basé sur la relation entre un niveau de tension de référence (Vréf) et la tension générée (Vr), contrôlant de ce fait d'une manière par rétroaction le faisceau laser de sortie de la diode laser à semi-conducteur (30) de telle sorte que le faisceau laser de sortie est maintenu sur un niveau prédéterminé ; et
un élément de polarisation (33) prévu entre la connexion commune de cathode de la diode laser à semi-conducteur (30) et la photodiode de monitor (31), et le conducteur de terre (G), l'élément de polarisation (33) appliquant une tension de polarisation d'inversion sur la photodiode de monitor (31),
**caractérisé en ce que** l'élément de polarisation est une résistance variable qui permet le réglage variable de la vitesse de la boucle de contrôle de rétroaction.

2. Circuit de commande du laser à semi-conducteur (26) selon la revendication 1, dans lequel l'élément de contrôle du courant (32) est prévu entre la connexion de cathode de la diode laser à semi-conducteur (30) et la photodiode de monitor (31), et le conducteur de terre (G).

3. Circuit de commande du laser à semi-conducteur (26) selon la revendication 2, dans lequel l'élément de contrôle du courant (32) est connecté en série à l'élément de polarisation (33) entre la connexion de cathode de la diode laser à semi-conducteur (30) et la photodiode de monitor (31), et l'élément de polarisation (33).

4. Circuit de commande du laser à semi-conducteur (26) selon l'une des revendications précédentes, dans lequel la tension de référence (Vréf) est fournie par l'intermédiaire d'une résistance variable de telle sorte que le niveau de tension de référence (Vréf) est variable de telle manière que le niveau résultant de sortie de la diode laser (30) est modifiable.

5. Circuit de commande du laser à semi-conducteur (26) selon l'une des revendications précédentes, dans lequel l'élément de contrôle du courant (32) comprend un transistor bipolaire.

6. Circuit de commande du laser à semi-conducteur (26) selon l'une des revendications précédentes, dans lequel l'élément de contrôle du courant (32) comprend un transistor à effet de champ.

7. Capteur photoélectrique (10) comprenant une unité d'émission de lumière (11) qui émet une lumière dirigée vers une région de détection prédéterminée (R1) et une unité de réception de lumière (21) qui reçoit une lumière depuis la région de détection (R1), accomplissant de ce fait une opération de détection en fonction d'un niveau de la lumière reçue par l'unité de réception de lumière (21), l'unité d'émission de lumière (11) incluant un circuit de commande du laser à semi-conducteur (26) pour un élément de laser à semi-conducteur incluant une diode laser à semi-conducteur (30) et une photodiode de monitor (31), les deux ayant des cathodes respectives connectées en commun, dans lequel la diode laser à semi-conducteur (30) a une anode connectée à un côté de conducteur d'alimentation en courant (L1) et dans lequel la photodiode de monitor (31) a une anode connectée à un côté de conducteur de terre (G) par l'intermédiaire d'une résistance (35) qui génère une tension conformément à une quantité de courant passant jusque dans la photodiode de monitor (31), le circuit de commande du laser à semi-conducteur (26) comprenant :
un élément de contrôle du courant (32) qui ajuste une quantité de courant fournie à la diode laser à semi-conducteur (30) ;
une unité de contrôle de rétroaction (34) qui reçoit une tension (Vr) générée par la résistance (35) afin de fournir un signal de contrôle (Vb) à un terminal de contrôle de l'élément de contrôle du courant (32) basé sur la relation entre un niveau de tension de référence (Vréf) et la tension générée (Vr), contrôlant de ce fait d'une manière par rétroaction le faisceau laser de sortie de la diode laser à semi-conducteur (30) de telle sorte que le faisceau laser de sortie est maintenu sur un niveau prédéterminé ; et
un élément de polarisation (33) prévu entre la connexion commune de cathode de la diode laser à semi-conducteur (30) et la photodiode de monitor (31), et le conducteur de terre (G), l'élément de polarisation (33) appliquant une tension de polarisation d'inversion sur la photodiode de monitor (31),
**caractérisé en ce que** l'élément de polarisation est une résistance variable qui permet la modification de la vitesse de la boucle de contrôle de rétroaction.

8. Capteur photoélectrique (10) selon la revendication 7, dans lequel l'élément de contrôle du courant (32) est prévu entre la connexion de cathode de la diode laser à semi-conducteur (30) et la photodiode de monitor (31), et le conducteur de terre.

9. Capteur photoélectrique (10) selon l'une ou l'autre des revendications 7 et 8, dans lequel l'élément de contrôle du courant (32) est connecté en série à l'élément de polarisation (33) entre la connexion de cathode de la diode laser à semi-conducteur (30) et la photodiode de monitor (31), et l'élément de polarisation (33).

10. Capteur photoélectrique (10) selon l'une des revendications 7, 8 ou 9, dans lequel la tension de référence (Vréf) est fournie par l'intermédiaire d'une résistance variable de telle sorte que le niveau de tension de référence (V_{réf}) est variable de telle manière que le niveau résultant de sortie de la diode laser (30) est modifiable.

11. Capteur photoélectrique (10) selon l'une des revendications 7 à 10, dans lequel l'élément de contrôle du courant (32) comprend un transistor bipolaire.

12. Capteur photoélectrique selon l'une des revendications 7 à 11, dans lequel l'élément de contrôle du courant comprend un transistor à effet de champ.
